# EUROPEAN PATENT SPECIFICATION

(11) **EP 1 299 946 B1**
(45) Date of publication and mention of the grant of the patent: **05.12.2007**
(21) Application number: 01949682.7
(22) Date of filing: 11.07.2001
(51) Int. Cl.: H03H 9/58

(54) **FILTER AND METHOD FOR MANUFACTURING THE SAME**
FILTERVORRICHTUNG UND VERFAHREN ZU DEREN HERSTELLUNG
FILTRE ET PROCÉDÉ POUR SA FABRICATION

(30) Priority: 11.07.2000 GB 0016861
(43) Date of publication of application: 09.04.2003
(73) Proprietor: TDK Corporation, Tokyo 103-8272 (JP)
(72) Inventor: WHATMORE, Roger, W., Milton Keynes MK3 7QR (GB); KOMURO, Eiju, Funabashi-shi, Chiba 276-0077 (JP)
(74) Representative: Wightman, David Alexander
(86) International application number: PCT/GB2001/003135
(87) International publication number: WO 2002/005425

(56) References cited:
- US-A- 5 185 589

## Description

The present invention concerns improvements in or relating to filters, and in particular to a method for hermetically packaging filters comprising a plurality of Bulk Acoustic Resonators (BARs) fabricated on a semiconductor or insulating wafer.

Thin Film Bulk Acoustic Resonators (FBARs) are attractive devices since they show resonant peaks at high frequency, particularly in the MHz and GHz regions. Moreover, FBARs can be used to make electronic filters which are very small in size (<1mm). Thus, they are considered to be useful for small, light, thin electrical appliance products, such as mobile telephones.

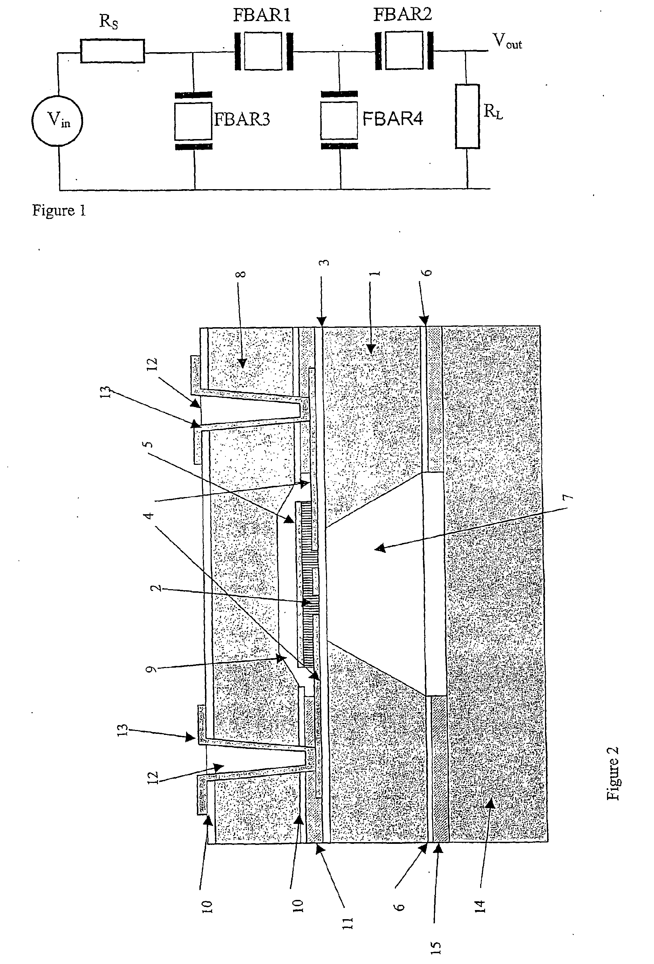

Figure 1 shows one example of a filter comprising four FBARs. The four FBARs are separated into 2 groups according to their functions in the filter. FBAR1 and FBAR2 in Figure 1 are connected in series. Therefore they form one group. Also, FBAR3 and FBAR4 are connected in parallel and form the other group. Usually all the FBARs are prepared simultaneously and on one substrate under the same procedures. Therefore each FBAR consists of very closely similar structures.

The typical design of an FBAR is well known. The basic physical structure of an FBAR consists of a thin piezoelectric layer made of some material such as ZnO, AlN or lead zirconate titanate (PZT) sandwiched between two conductive electrodes, usually made of a metal such as aluminium or gold. Usually the piezoelectric layer is freely suspended by etching away part of the substrate immediately below the active part of the piezoelectric layer, although in some versions of the device, the underlying substrate is not removed, but a multi-layer structure is deposited immediately under the active piezoelectric layer. This serves to reflect acoustic power back from the substrate into the resonator and such a structure is known as a solidly-mounted resonator or SBAR. Both types of device structure are well known.

As the piezoelectric membrane is very thin (in either type of structure), its resonant frequency is very sensitive to any contaminants mass-loading the membrane or layer surface. The membrane in the FBAR structure, while usually quite strong, could also be considered to be physically vulnerable to the kind of handling that electronic devices receive in the automatic assembly equipment used to populate electronic printed circuit boards or multi-chip modules. It is important therefore that these devices are packaged prior to use. This package should be hermetically sealed against the penetration of unwanted contaminants, robust and add as little as possible to the area of the basic filter device. It should also be as low in cost and as small as possible.

US-A-5185589 discloses a film bulk acoustic resonator configured as a coplanar line structure that eliminates the need for wire band connections to the resonator.

The present invention has been made from a consideration of the foregoing and seeks to provide a technique for hermetically packaging such devices which meets at least some of these requirements.

Thus, the present invention provides a method for hermetically packaging a filter as defined in claim 1.

In a preferred application of the method for packaging a radio frequency or microwave filter which comprises plural thin film bulk acoustic resonators (FBARs), the filter comprises a plurality of FBARs of which at least one FBAR is in series and one FBAR in parallel.

Each FBAR preferably comprises a plurality of layers consisting of (from lower to upper): a substrate, a dielectric layer, one or more metal layers acting as a lower electrode, a piezoelectric layer, one or more metal layers acting as an upper electrode and any top layer (optional) which might be added to effect further adjustable mass loading. This final layer can be either a conductor or an insulator.

Generally, a plurality of separate FBAR filter devices may be fabricated simultaneously on one substrate using the well known techniques of photolithographic patterning and etching which have been developed for the semiconductor industry. These devices are separated into individual devices by sawing after fabrication.

The package consists of at least one wafer of material, which should ideally be a material selected to give good thermal expansion match to the material used for the substrate used to bear the FBAR filters, said wafer or wafers being bonded to the wafer bearing the FBAR filter, and having previously been etched or micromachined to form a cavity over the active area of the FBAR device. The wafer or wafers bonded to the FBAR substrate are micromachined to provide openings, through which electrical contacts can be made to the signal and earth lines of the FBAR filters. The individual filters are separated after processing by sawing into individual components.

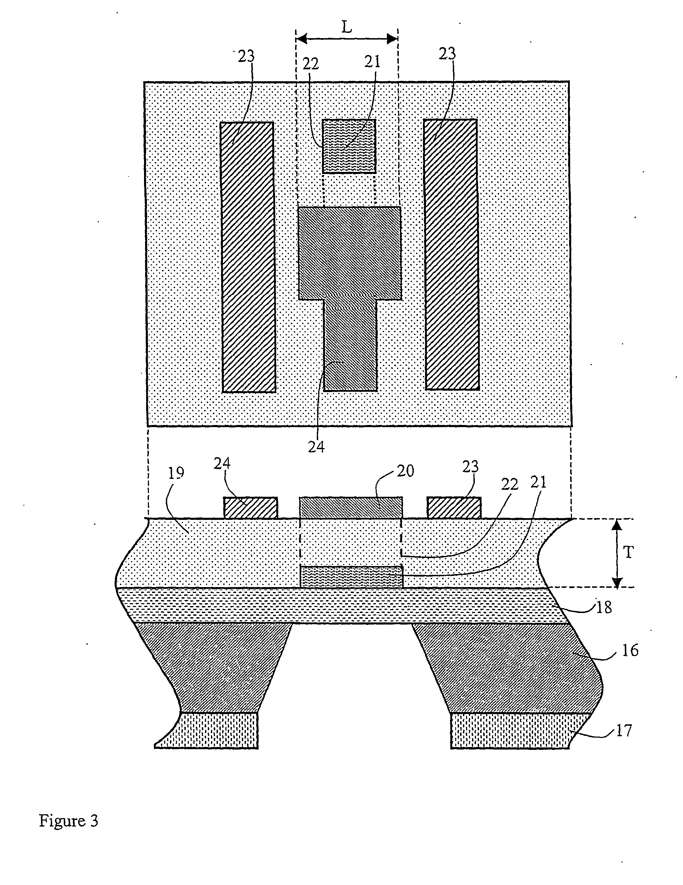

One embodiment of an FBAR device produced by the method according to the present invention is shown schematically in Figure 2. Here wafer 1 is the wafer bearing the FBAR filter. In this device, layer 2 is the piezoelectric material, layer 3 is an etch-stop layer such as silicon nitride, layers 4 and 5 are metal layers forming upper and lower electrodes for the FBAR resonators, layer 6 is another layer of a material such as SiO₂ or silicon nitride forming an etching mask on the back face of wafer 1. The cavity 7 is formed by bulk micro-machining of wafer 1 in order to release the layers carrying the FBAR resonators.

Wafer 8 is a second wafer sealing over the FBAR devices on wafer 1. A cavity or well 9 is bulk micro-machined into this wafer by etching through holes in a layer 10 made of a material such as silicon nitride. This wafer 8 is bonded to wafer 1 by means of a bonding layer 11. Holes 12 are etched into wafer 8 by means of a process such as deep reactive ion etching using another layer 10 of a material such as silicon nitride and an electrode metal 13 deposited into these holes to make contact with the electrode tracks 4 leading to the FBAR resonators.

Optionally, a third wafer 14 is bonded to the back face of wafer 1 using a bonding layer 15. This forms a protective seal to the rear cavities of the device. Clearly, this would not be required for those FBAR devices which are formed by etching from the front face alone, or for SBAR devices.

It should be appreciated that many FBAR filter devices can be made on a single wafer of a material such as silicon and the basic principle of this invention is that the processing of the FBAR devices, and the processing and bonding of the sealing wafers is done on a wafer-scale. The individual packaged FBAR devices are only separated one from another by sawing after the packaging operation is complete.

Other features, benefits and advantages of the present invention will be understood from the following description, given by way of example only, with reference to the accompanying drawings wherein:
**Figure 1** illustrates a schematic diagram of a preferred filter which comprises two FBARs in series and two FBARs in parallel;
**Figure 2** illustrates a schematic diagram of one possible embodiment of a complete packaged FBAR according to this invention;
**Figure 3** illustrates a top view and a cross section view of an FBAR;
**Figure 4** shows a plurality of FBAR resonators connected in series / parallel arrangement to make a ladder filter;
**Figure 5** illustrates Wafer A bearing the FBAR filters and Wafer B, being the first wafer to be bonded to Wafer A, and how wells are etched into face B1 of Wafer B to accommodate the FBAR filters;
**Figure 6** illustrates Wafers A and B bonded together to make a composite Wafer AB and Wafer C, the wafer used to seal the back face cavities on Wafer A;
**Figure 7** illustrates the composite Wafer ABC with the holes etched into the face B2 to make contact with the metal tracks leading to the FBAR filters;
**Figure 8** illustrates how the holes etched into face B2 are filled with metal and contact pads made on the surface; and
**Figure 9** illustrates how contact pads can be deposited on the edges of the chip bearing the FBAR filter.

A typical preparation procedure for an FBAR filter, comprising six FBARs, is described first as follows with reference to Figure 3. Firstly, silicon nitride (SiNₓ) is coated to 200nm thickness with chemical vapor deposition onto both sides of a bare Si wafer 16. The SiNₓ membrane layer 18 is also at the front side of the Si wafer 16. At the back side of the Si wafer 16, patterns are prepared with photolithograpy and reactive ion etching in the SiNₓ, as defined by the backside layer pattern 17.

A bottom electrode 21 is prepared with the so-called lift-off process which is carried out as follows. First a pattern of photoresist is prepared with photolitliograpy. Then, chromium and gold (Cr/Au) are deposited by sputtering at thicknesses at 10nm and 100nm, respectively. Cr is used as an adhesion layer for the Au. Next, the patterned photoresist and Cr/Au on it are removed with acetone because the photoresist dissolves in acetone. After that procedure, a bottom electrode 21 is obtained.

Next, zinc oxide (ZnO) is deposited to form the piezoelectric layer 19 by sputtering. The thickness of the piezoelectric layer 19 is 1.2 microns. The piezoelectric layer 19 is etched with acetic acid to make a contact hole 22 in order to touch a bottom electrode 21 with an electrical probe.

Afterwards, a top electrode 20 is prepared by the lift-off process. The top electrode 20 has a transmission line and a square working area 24 on which one dimension is 200 microns, shown as L in Figure 2. The working area size is the same for the bottom electrode 21.

When the top electrode 20 is prepared, two ground electrodes 23 are prepared as well under the same lift-off process, so the top electrode 20 has a coplanar wave-guide structure for which the characteristic impedance is set at about 50 ohms.

Finally, the Si wafer 16 is etched from its backside with KOH solution, using the backside pattern layer 17 and the preparation process for the filter is finished. It is well known that it is normal to make the FBAR resonators in series and in parallel with different areas.

The filter description written above is only one example of a type of FBAR which can be packaged according to this invention. Thus, the thin film techniques and materials for any or each layer of the preferred filter described above are not restricted to be as described.

For example, the material for the piezoelectric layer 19 is not restricted to be ZnO. Aluminum nitride (A1N) which shows a high Q value and lead titanate zirconate (PZT) which shows a large electromechanical coefficient could be used as alternatives. Also, lead scandium tantalum oxide and bismuth sodium titanium oxide could be used as alternatives. The material for the top electrode 20 and bottom electrode 21 are not restricted to be Cr/Au. Aluminum (Al) and platinum (Pt), which are often used for electrodes could be used as alternatives. The material for the membrane layer 18 and the backside pattern layer 17 is not restricted to be SiNₓ. SiO₂ could be used as an alternative.

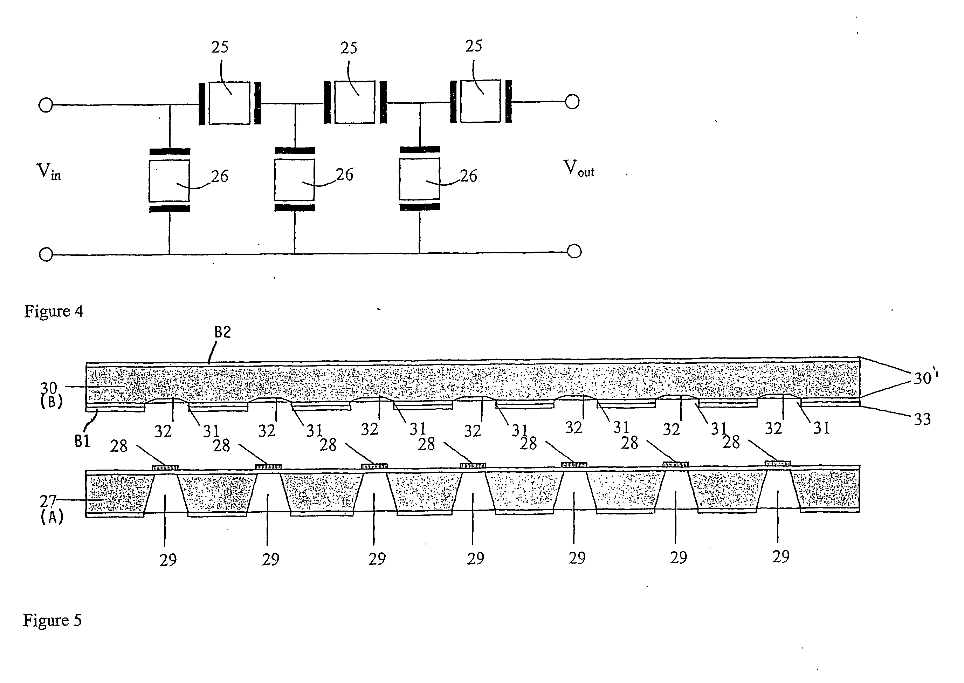

Figure 4 shows a ladder filter which would use six of these FBAR resonators wired in series 25 and parallel 26. The numbers of FBARs in series 25 and FBARs in parallel 26 are not restricted to 3 each. These numbers should be decided by the need for a particular level of close-in rejection, the required area size for the filter and so on.

FBARs which are used as a FBAR in series 25 and a FBAR in parallel 26, are not restricted to be an FBAR which comprises an etched hole on Si wafer 20 at the backside of a bottom electrode 21. An air gap under the resonant layer can be created by some other etching method such as deep reactive ion etching from the back of the wafer 16 or etching the substrate material from the front of the wafer so that a well propagates sideways under the resonant layer, or by etching a sacrificial material from under the piezoelectric layer from the front of the wafer. Alternatively, a multi-layer Bragg reflector may be used at the backside of the bottom electrode 21.

Furthermore, wafer 16 is not necessarily made from Si. Another type of substrate can be used for the FBAR filter, such as sapphire or magnesium oxide. Furthermore, the FBAR filter can comprise more than one piezoelectric layer which are designed to couple with one another acoustically. All of the FBAR filters so described can be packaged hermetically on a wafer scale by using the method described in this invention.

A description of a particular method for making the FBAR filters, hermetically encapsulated or packaged on a wafer scale will now be given with reference to Figures 5 to 8. In this case, the example will be given of devices made on silicon wafers, but it will be readily appreciated that the description could equally well be applied to devices which are made on wafers other than silicon.

Firstly, a wafer bearing a plurality of FBAR filters is fabricated as described in the preceding paragraphs. In this case, referring to Figure 5, there is shown a wafer 27 (called here Wafer A) bearing a plurality of FBAR filters 28 made according to an FBAR filter design consisting of several individual linked FBAR resonators with one or more cavities 29 etched underneath the active portions of the piezoelectric layer.

A second wafer 30 (called here Wafer B) is fabricated with wells 32 etched in the surface so that the positions of the wells 32 coincide with the active portions of the FBAR filters 28 on the first wafer 27 when the two wafers are placed face-to-face. This is accomplished as described below.

Firstly, Wafer B is coated on both faces with layers of silicon nitride 30'. A layer of a bonding medium 33 is deposited onto the face (here called face B1 - the opposite face of this wafer being face B2). Face B1 will eventually be bonded to Wafer A. Suitable bonding media would be a borosilicate glass if anodic bonding were to be used. Alternatively a low melting point glass could be deposited. Such glasses can be deposited by a process such as RF magnetron sputtering.

Windows 31 are opened in the silicon nitride (using photolithography and dry etching). The positions of these windows 31 are fixed to match the positions of the active regions of the FBAR filters 28 on Wafer A. Wells 32 are etched in face B1 by exposing the face to a suitable etching medium. In the case of a silicon wafer this would be, for example, a solution of KOH in propanol or a mixture of ethylenediamine and pyrocatechol. Alternatively a dry etching technique could be used to achieve a similar end. The depth of the well 32 has to be sufficient (typically a few micrometers) simply so that the FBAR resonators are not in contact with any part of Wafer B when the two wafers A and B are brought together.

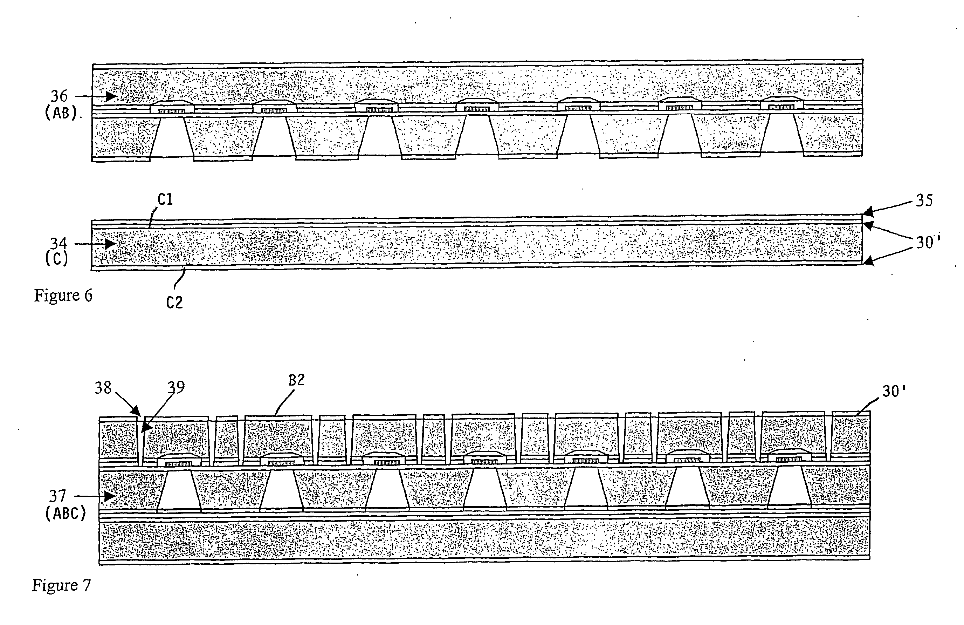

Wafers A and B are then cleaned to remove any particulate debris or other surface contaminants and brought together in proper alignment and bonded, preferably under a vacuum so that the wells 32 are evacuated. An anodic bond can be created by raising the temperature of the wafers to a few hundred degrees centigrade and applying a potential difference between the wafers of a few hundred volts. Alternatively, if a low melting point glass is used as the bonding medium, the temperature of the wafers can be raised to a temperature close to the melting point of the glass and a pressure applied to the wafers to effect a bond. Alternatively, a suitable metal or alloy layer can be deposited onto both faces to be bonded together prior to them being brought together for bonding again under elevated temperature and with applied pressure. The Wafers A and B are thus bonded together to form a composite wafer 36 (called here Wafer AB) as shown in Figure 6.

The next stage of the process is to seal the back face of Wafer A by bonding a third wafer 34 (called here Wafer C) to it. As shown in Figure 6, Wafer C is coated on both faces C1, C2 with layers of silicon nitride 30' and on face C1 with a layer 35 of one of the bonding media as described previously. After thorough cleaning, also as described previously, this face C1 is brought into contact (preferably under vacuum so that the cavities 29 are evacuated) with the back face of the composite Wafer AB (36) and bonded to it as described previously (for example through anodic bonding). This yields a composite wafer 37 (called here Wafer ABC) formed by a stack of three wafers A, B, C all bonded together as shown in Figure 7.

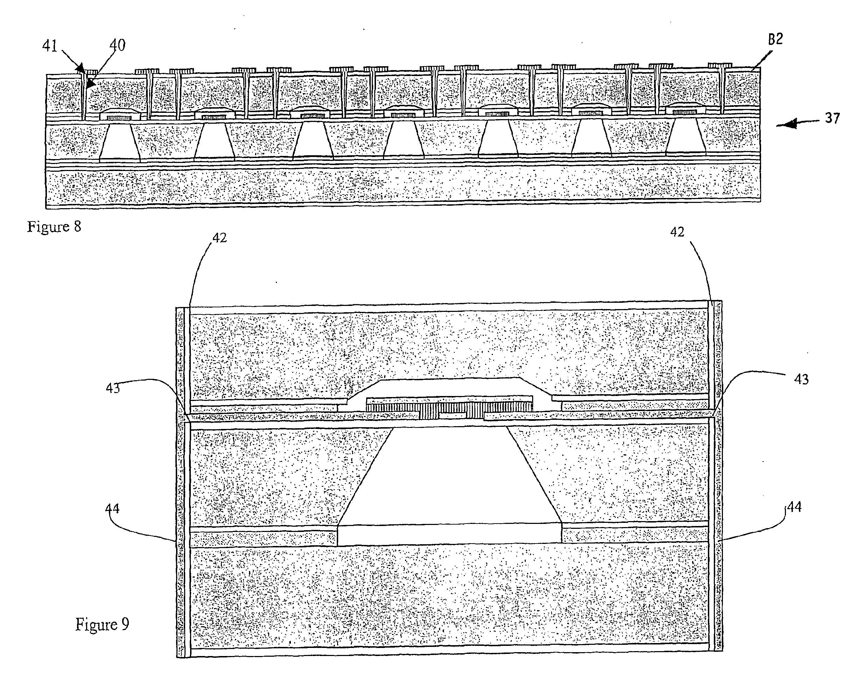

The final stage in the process is to make contact with the metal tracks 20, 21, 23 and 24 of the FBAR devices. This is achieved by etching via holes 39 through face B2 of the composite Wafer ABC as described below with reference to Figures 7 and 8.

Windows 38 are opened in the silicon nitride layer 30' on face B2. These are positioned so that when holes 39 are etched through these windows (preferably, although not essentially using a dry deep reactive ion etching process), the holes 39 that are produced will eventually intersect with the metal tracks. Any residual silicon nitride or oxide is removed by a combination of dry and/or wet etching to expose the said metal tracks.

The insides of the holes 39 are then coated with an insulating layer and filled with metal 40 as shown in Figure 8 using either thermal evaporation, sputtering, electroless plating, electro-plating or some combination of these or similar methods and the metal on the surface B2 is patterned to leave contact pads which can subsequently be used to make electrical contact through to the metal tracks leading to the FBAR filter. The wafer processing is then complete and the individual devices can be separated by sawing or by etching deep grooves in the faces of the composite silicon wafer using a deep reactive ion etching process.

It will readily be appreciated that this technique of wafer scale hermetic packaging can easily be applied to FBAR filters which are made on substrates other than silicon, for example sapphire. It will also be appreciated that the method can be applied to other types of FBAR or SBAR filters. For example, if the FBAR filter is of the design where no etching is applied from the back face of the wafer to release the resonant membrane, but the etching is done entirely from the front face, then the Wafer C in the above description can be dispensed with and the hermetic package made with Wafer B alone. In this case the contact holes can be etched from either side of the resulting composite wafer.

It is also possible to make contact to the metal tracks leading to the FBAR filters without the need to make holes in the composite wafer. This can be achieved by sawing the composite wafers so that the saw cuts intersect the ends of the metal tracks, thus leaving them exposed at the edge of each chip bearing a filter. This is illustrated in Figure 9. The edges of the chips on which, the tracks are exposed are first coated with an insulating layer 42. This can be a vapour deposited polymer or a metal oxide or nitride. Holes 43 are opened in this insulating layer and the metal tracks can then be contacted by applying metal layers 44 to the edges of the chip.

As will now be understood, a method is provided according to this invention by which filters consisting of a plurality of thin film bulk acoustic resonators (FBAR) fabricated on a semiconductor wafer such as silicon or some other type of wafer can be hermetically packaged in a way that presents a component such as a chip which can be easily handled by conventional pick-and-place machines.

The foregoing description is intended to be illustrative of the benefits and advantages of the invention and it will be understood that variations and modifications can be made within the scope of the claims hereto.

## Claims

1. A method for hermetically packaging a filter including bulk acoustic resonators (28) **characterised by** including the steps of providing a first wafer (1;27) bearing a plurality of bulk acoustic resonators (28), providing a second wafer (8;30) having a plurality of wells (9;32), bonding the first and second wafers (1,8;27,30) to each other to form a composite wafer (1,8;36) in which the bulk acoustic resonators (28) of the first wafer (1;27) are aligned with the wells (9;32) of the second wafer (8;30), and separating individual filters (28) from the composite wafer (1,8,36).

2. A method as claimed in claim 1 wherein each filter (28) includes a piezoelectric layer (2;19) sandwiched between two metal electrodes (4,5;20,21).

3. A method as claimed in claim 1 or claim 2 wherein holes (12;39) are etched and filled with metal (13;40) to allow contacts to be made to the filters (28).

4. A method as claimed in claim 1 or claim 2 wherein metal layers (44) are deposited on the edges of the filters (28) after they have been separated in order to allow contacts to be made to the filters (28).

5. A method as claimed in any one of the preceding claims wherein a third wafer (14;34) is bonded to the first wafer (1;27) on that face remote from the second wafer (8;30).

6. A method as claimed in any one of the preceding claims wherein one or more of the wafer bonding processes is undertaken under a vacuum.

7. A method as claimed in any one of the preceding claims wherein one or more of the wafer bonding processes used is anodic bonding employing a borosilicate bonding layer.

8. A method as claimed in any one of claims 1 to 6 wherein one or more of the wafer bonding processes used employs a low melting point glass as the bonding layer and the bond is made by a combination of heat and pressure.

9. A method as claimed in any one of claims 1 to 6 wherein one or more of the wafer bonding processes used employs a metal or alloy as the bonding layer and the bond is made by a combination of heat and pressure.

10. A filter made by the method according to any one of the preceding claims.

11. A filter according to claim 10 including a piezoelectric layer (2;19) sandwiched between two metal electrodes (4,5;20,21).

12. A filter according to claim 11 comprising a plurality of layers consisting of a substrate, a dielectric layer, one or more metal layers acting as a lower electrode, a piezoelectric layer, and one or more metal layers acting as an upper electrode.

13. A filter according to claim 12 further comprising a top layer which can be either a conductor or an insulator.

14. A filter according to claim 10 comprising an SBAR filter.

## Patentansprüche

1. Verfahren zum hermetischen Verpacken eines Filters einschließlich Bulk-Akustik-Resonatoren (28), **dadurch gekennzeichnet, dass** es folgende Schritte umfasst: Bereitstellen eines ersten Plättchens (1;27), welches eine Vielzahl von Bulk-Akustik-Resonatoren (28) trägt, Bereitstellen eines zweiten Plättchens (8;30), welches eine Vielzahl von Betten (9;32) aufweist, Verbinden des ersten und des zweiten Plättchens (1,8;27,30) miteinander, um ein Kompositplättchen (1,8;36) zu bilden, in welchem die Bulk-Akustik-Resonatoren (28) des ersten Plättchens (127) zu den Betten (9;32) des zweiten Plättchens (8;30) ausgerichtet sind, und Abtrennen der Einzelfilter (28) von dem Kompositplättchen (1,8;36).

2. Verfahren nach Anspruch 1, wobei jeder Filter (28) eine piezoelektrische Schicht (2;19) einschließt, die zwischen zwei Metallelektroden (4,5;20,21) sandwichartig angeordnet ist.

3. Verfahren nach Anspruch 1 oder 2, wobei Löcher (12;39) geätzt und mit Metall (13;40) gefüllt sind, um es zu ermöglichen, Kontakte zu den Filtern (28) herzustellen.

4. Verfahren nach Anspruch 1 oder 2, wobei Metallschichten (44) an den Kanten der Filter (28) abgelagert werden, nachdem diese abgetrennt wurden, um es zu ermöglichen, Kontakte zu den Filtern (28) herzustellen.

5. Verfahren nach einem der vorstehenden Ansprüche, wobei ein drittes Plättchen (14;34 mit dem ersten Plättchen (1 ;27) auf der Fläche verbunden ist, die von dem zweiten Plättchen (8;30) entfernt liegt.

6. Verfahren nach einem der vorstehenden Ansprüche, wobei ein oder mehrere der Plättchenverbindeverfahren unter Vakuum durchgeführt werden.

7. Verfahren nach einem der vorstehenden Ansprüche, wobei das verwendete ein oder mehrere Plättchenverbindungsverfahren ein anodisches Verbinden unter Verwendung einer Borsilikatverbindungsschicht ist.

8. Verfahren nach einem der Ansprüche 1 bis 6, wobei das ein oder mehrere Plättchenverbindungsverfahren ein Glas mit niedrigem Schmelzpunkt als Verbindungsschicht verwendet und dass die Verbindung durch eine Kombination von Hitze und Druck hergestellt wird.

9. Verfahren nach einem der Ansprüche 1 bis 6, wobei das verwendete ein oder mehrere Plättchenverbindungsverfahren ein Metall oder eine Legierung als Verbindungsschicht verwendet und die Verbindung durch eine Kombination von Wärme und Druck hergestellt wird.

10. Filter, hergestellt nach dem Verfahren gemäß einem oder mehreren der vorstehenden Ansprüche.

11. Filter nach Anspruch 10 einschließlich einer piezoelektrischen Schicht (2; 19), welche sandwichartig zwischen zwei Metallelektroden (4,5;20,21) angeordnet ist.

12. Filter nach Anspruch 11, umfassend eine Vielzahl von Schichten, bestehend aus einem Substrat, einer dielektrischen Schicht, einer oder mehrerer Metallschichten, die als untere Elektrode wirken, einer piezoelektrischen Schicht und einer oder mehrerer Metallschichten, die als obere Elektrode arbeiten.

13. Filter nach Anspruch 12, ferner umfassend eine oberste Schicht, welche entweder ein Leiter oder ein Isolator sein kann.

14. Filter nach Anspruch 10, umfassend einen SBAR-Filter.

## Revendications

1. Procédé pour emballer hermétiquement un filtre incluant des résonateurs acoustiques en volume (28), **caractérisé en ce qu'**il comprend les étapes consistant à réaliser une première plaquette (1;27) supportant plusieurs résonateurs acoustiques en volume (28), réaliser une deuxième plaquette (8;30) présentant plusieurs puits (9;32), lier les première et deuxième plaquettes (1,8;27,30) l'une à l'autre pour former une plaquette composite (1,8;36) dans laquelle les résonateurs acoustiques en volume de la première plaquette (1;27) sont alignés avec les puits (9;32) de la deuxième plaquette (8;30) et séparer des filtres individuels (28) de la plaquette composite (1,8;36).

2. Procédé selon la revendication 1, où chaque filtre (28) comprend une couche piézoélectrique (2;19) prise en sandwich entre deux électrodes métalliques (4,5;20,21).

3. Procédé selon la revendication 1 ou 2, où les trous (12;39) sont attaqués et remplis avec un métal (13;40) pour permettre l'établissement de contacts aux filtres (28).

4. Procédé selon la revendication 1 ou 2, où les couches métalliques (44) sont déposées sur les bords des filtres (28) après qu'ils ont été séparés pour permettre l'établissement des contacts aux filtres (28).

5. Procédé selon l'une des revendications précédentes, où une troisième plaquette (14;34) est liée à la première plaquette (1;27) sur la face éloignée de la deuxième plaquette (8;30).

6. Procédé selon l'une des revendications précédentes, où un ou plusieurs processus de liaison de plaquette sont exécutés sous vide.

7. Procédé selon l'une des revendications précédentes, où un ou plusieurs des processus de liaison de plaquettes utilisés est une liaison anodique utilisant une couche de liaison en borosilicate.

8. Procédé selon l'une des revendications 1 à 6, où un ou plusieurs des processus de liaison de plaquettes utilisés emploie un verre d'un point de fusion bas comme couche de liaison, et la liaison est faite par une combinaison de chaleur et de pression.

9. Procédé selon l'une des revendications 1 à 6, où un ou plusieurs processus de liaison de plaquettes utilisé utilise un métal ou alliage comme couche de liaison, et la liaison est faite par une combinaison de chaleur et de pression.

10. Filtre réalisé selon le procédé selon l'une des revendications précédentes.

11. Filtre selon la revendication 10, comprenant une couche piézoélectrique (2;19) prise en sandwich entre deux électrodes métalliques (4,5;20,21).

12. Filtre selon la revendication 11, comprenant plusieurs couches constituées d'un substrat, d'une couche diélectrique, d'une ou de plusieurs couches métalliques agissant comme électrode inférieure, d'une couche piézoélectrique et d'une ou de plusieurs couches métalliques agissant comme électrode supérieure.

13. Filtre selon la revendication 12, comprenant en outre une couche supérieure qui peut être soit un conducteur soit un isolateur.

14. Filtre selon la revendication 10, comprenant un filtre SBAR.
